# EUROPEAN PATENT SPECIFICATION

(11) **EP 0 323 190 B1**
(45) Date of publication and mention of the grant of the patent: **05.03.1997**
(21) Application number: 88312300.2
(22) Date of filing: 23.12.1988
(51) Int. Cl.: H01L 39/12, C04B 35/00

(54) **Superconductive metal oxide material**
Supraleitendes Metalloxydmaterial
Matériau supraconducteur à base d'oxyde métallique

(30) Priority: 28.12.1987 JP 336479/87; 23.03.1988 JP 67337/88
(43) Date of publication of application: 05.07.1989
(73) Proprietor: CANON KABUSHIKI KAISHA, Tokyo (JP)
(72) Inventor: Akimitsu, Jun, Tokyo (JP); Den, Tohru, Tokyo (JP); Kishi, Fumio, Atsugi-shi Kanagawa-ken (JP); Kaneko, Norio, Atsugi-shi Kanagawa-ken (JP); Akaike, Masatake, Atsugi-shi Kanagawa-ken (JP); Niizuma, Kiyozumi, Atsugi-shi Kanagawa-ken (JP); Tanaka, Atsuko, Machida-shi Tokyo (JP)
(74) Representative: Beresford, Keith Denis Lewis

(56) References cited:
- EP-A- 0 316 009
- ZEITSCHRIFT FÜR PHYSIK B, vol. 68, September 1987, pages 417-419, Berlin, DE; C. MICHEL et al.: "Introduction of Bismuth into the High Tc Superconductor La2-xSrxCuO4-y"
- JAPANESE JOURNAL OF APPLIED PHYSICS, vol. 26, no. 12, December 1987, pages L2080-L2081, Tokyo, JP; J. AKIMITSU et al.: "Superconductivity in the Bi-Sr-Cu-O system"
- JAPANESE JOURNAL OF APPLIED PHYSICS, vol. 27, no. 9, September 1988, pages L1620-L1622, Tokyo, JP; T. DEN et al.: "The superconductivity in the Bi-Sr-Ln-Cu-O system (Ln=Pr, Nd and La)"

## Description

### BACKGROUND OF THE INVENTION

### Field of the invention

The present invention relates to a copper oxide material, and particularly to a copper oxide material useful as a superconductive material.

More particularly it is concerned with a novel copper oxide material that contains bismuth, an alkaline earth metal and at least one element selected from the group consisting of lanthanoid elements and yttrium, and exhibits superconductivity at the boiling point of liquid helium or higher.

### Related Background Art

Hitherto known as copper oxides are CuGeO₃, CuNbO₃, CuVO₃, Bi₂CuO₄, Cr₂CuO₄, La₂CuO₄, etc. as well as CuO and Cu₂O. Of these, La₂₋ₓAₓCuO₄ (A = Ca, Sr or Ba) and LnBa₂Cu₃O_{y} (Ln = Y or lanthanoids) are known as superconductive materials.

However, in the conventional superconductive materials comprising copper oxides, the yttrium and lanthanoids that are component elements of the materials have been expensive materials because of their small estimated amounts of the resource. In instances in which these copper oxides are formed into sinters or thin films depending on what they are used for, high temperatures of about 1,000°C are required for reaction, bringing about the problems that a high production cost results and there are considerable limitations on substrates to be used. Moreover, they also can be formed into single crystals with difficulty and with restricted reaction conditions, so that no large single crystal has ever been obtained. Furthermore, deviation in compositional ratios may greatly affect the superconductivity transition temperature (hereinafter "Tc"), having brought about the problem such as the materials Y₁₊ₓBa₂₋ₓCu₃O₇ exhibit no superconductivity within the range of x ≧ 0.2. This is particularly a great problem since the compositional deviation becomes liable to occur when thin films are prepared.

Z. Phys. B-Condensed Matter 68, 421-423 (1987) discloses a novel bismuth-based superconductive material, having its composition of Sr₂Bi₂Cu₂O_{7+δ} , and Tc of 7 to 22 K in the midpoint. This bismuth-based superconductive material does not employ any expensive starting materials such as Y and lanthanoids as its component elements, can be formed using reacting temperatures of not higher than 900°C, can be inexpensive when compared with conventional La₂₋ₓAₓCuO₄ and LnBa₂Cu₃O_{y}, and can afford to accept a broader scope of selection in respect of the materials for substrates for thin film formation, and thus can be said to be superior materials in these respects. The Tc thereof, however, tends to be significantly lowered by contamination with impurities, and it is difficult to obtain a superconductive material having a stable Tc that it is required to use starting materials purified in a high degree.

### SUMMARY OF THE INVENTION

The present invention provides a metal oxide material as defined in claim 1.

The above mentioned metal oxide material provides a novel copper oxide based superconductor which is less expensive to manufacture than prior art superconductors because it does not require so much expensive lanthanoid starting material. Embodiments of the above superconductive copper oxide material can be formed at a low reaction temperature and enable single crystals to be prepared easily. Embodiments of the superconductive material have a Tc which is less affective by compositional deviations, and readily exhibit superconductivity when cooled to liquid helium temperatures. Furthermore, embodiments of the present copper oxide material are less subject to deterioration of Tc as a result of the presence of small amounts of impurities and can be prepared using ordinary starting materials not of specially high purity.

### BRIEF DESCRIPTION OF THE DRAWINGS

Fig. 1 shows the X-ray pattern of the product of Example 10.

Fig. 2 shows the X-ray pattern of the product of Example 18.

### DETAILED DESCRIPTION OF THE PREFERRED EMBODIMENTS

The present invention relates to a metal oxide material characterized by its composition represented by the formula:

LnₓBi_{y}A_{z}CuO_{δ}

wherein Ln represents a lanthanoid, or yttrium and A represents an alkaline earth metal.

The copper oxide material of the present invention may have any composition within the range represented by the above compositional formula, but a material preferred in the present invention is a metal oxide material represented by the above compositional formula wherein Ln is at least one element selected from the group consisting of Y, Pr, Nd, Sm, Eu, Gd,Tb, Dy, Ho, La, Er and Ce; A is at least one element selected from the group consisting of Ca, Sr, Ba and Mg, and 0.01 ≦ x ≦ 0.5, 0.5 ≦ y < 3, 0.5 ≦ z < 3, and 3 < δ.

When laying stress on the superconductivity characteristics, particularly preferred out of the metal oxide material of the present invention is that 0.2 ≦ x ≦ 0.35, 1.8 ≦ y ≦ 2.2, 2.6 ≦ z ≦ 2.8, and 3 ≦ δ ≦ 7.3 in the above compositional formula.

In particular, a material whose Tc can be less affected by the compositional deviation, of course taking account of the superconductivity characteristics, is a material represented by the compositional formulas: BiSr₁₋ₓLnₓCuO_{δ} (x = 0.1 ± 0.02, and preferably 3.5 ≦ δ ≦ 3.6), Bi₂(Sr₁₋ₓLnₓ)₂CuO_{δ} (0 ≦ x < 0.5, and preferably 6 ≦ δ ≦ 6.5), or BiSr_{1.5-x}LnₓCuO_{δ} (0.1 ≦ x ≦ 0.2), among which a material represented by BiSr_{1.5-x}LnₓCuO_{δ} (0.1 ≦ x ≦ 0.2) exhibits high Tc

As methods of preparing the above copper oxide materials of the present invention, any of reaction and sintering methods can be employed which utilizes heating of starting material powders generally used for ceramic materials.

Examples of such methods are disclosed in Material Research Bulletin, Vol. 8, p.777 (1973); Solid State Communication, Vol. 17, p.27 (1975); Zeitschrift für Physik, Vol. B-64, p.189 (1986); Physical Review Letters, Vol. 58, No. 9, p.908 (1987); etc., and these methods are presently known qualitatively as very common methods.

A method of effecting single-crystal growth after a starting material powder has been melted at a high temperature is also useful in the present invention. Still also, the material of the present invention may be formed on a substrate in a form of a thin film by means of sputtering such as radio frequency sputtering and magnetron sputtering, using a target containing starting materials, electron beam vapor deposition, or other vacuum vapor deposition, as well as a cluster ion beam method, or CVD or plasma CVD employing gaseous materials as starting materials. In such instances, it is often effective to feed gaseous oxygen to carry out oxidation in the apparatus. More specific examples of conditions for the preparation will be described in Examples herein set out below.

The copper oxide material of the present invention, obtained in this way, does not exhibit the metal-nonmetal transition, has an electrical resistivity of about 10⁻⁴ to 10⁻¹ Ω·cm at room temperature, and preferably exhibits a superconductivity at temperatures of not less than 20 K.

A preferable superconductivity can be obtained when x, y, z and δ are respectively within the above range in the above compositional formula. No preferable superconductive state may result if they are out of the above range.

The principal starting materials used in the present invention are all inexpensive, promising a low starting material cost, so that the oxide material of the present invention can be provided at a low cost. For example, the oxide material of the present invention can be provided at a lower cost even when compared with a series of the compounds represented by YBa₂Cu₃O_{7-z}. Ordinary commercially available products having a purity of from 99.5 to 99.9 % can also be used as the starting materials, so that the oxide material of the present invention can be prepared at a cost lower than Sr₂Bi₂Cu₂O_{δ} which requires starting materials having a higher purity. Also, the oxide material of the present invention is relatively stable with less deterioration in the atmosphere as compared with the above compounds, and may suffer less deterioration by moisture.

Since in addition the Tc of the resulting oxide material is higher than the temperature of liquid helium (4.2 K), it can be relatively easily used as the superconductive material.

It is also possible to carry out the reaction in preparing the material at a low temperature of 900°C or lower, and achieve good crystallinity. Therefore the material is very advantageous when formed into a thin film. In particular, in the present invention, a material represented by the compositional formula (A) : BiSr₁₋ₓLnₓCuO_{δ} (x = 0.08 to 0.12, and 3.5 ≦ δ ≦ 3.6) a material represented by the compositional formula(B) : Bi₂(Sr₁₋ₐLnₐCuO_{δ} (0 ≦ a < 0.5, and 6 ≦ δ ≦ 6.5), and a material represented by the compositional formula (C) : BiSr_{1.5-x}LnₓCuO_{δ} (0.1 ≦ x ≦ 0.2, and δ ≧ 3) have superior characteristics, particularly having a good crystallinity. In the case of the present material, there are the advantages that good characteristics can be retained even when the composition deviates from the above values within a certain extent, and, when formed into thin films, the oxide materials are less adversely affected by the compositional deviation as compared with the case of YBa₂Cu₃O₇₋₈. From the viewpoint of high Tc, particularly preferable as Ln are Pr, Sm, Eu, Gd, La, and Nd in the compositional formulas (A) and (B); and Y, Pr, Nd, Sm, Eu, Gd, Tb, Dy and Ho in the compositional formula (C).

As described above, the present invention can bring about the following advantages:
(1) A novel copper oxide material can be obtained which exhibits superconductivity at not lower than the liquid helium temperature (4.2 K), and preferably not lower than 20 K.
(2) A novel copper oxide material having a high critical current value can be obtained.
(3) A copper oxide material having a high Tc can be obtained without using lanthanoid elements in a large quantity but using inexpensive materials.
(4) A copper oxide material can be obtained at a relatively low reacting temperature of 900°C or lower with good crystallinity.
(5) A practically useful copper oxide material can be obtained whose superconductivity transition temperature can be less affected.
(6) It is not required to use starting materials purified in a particularly high degree, since the Tc is not affected by impurities if they are present in a small amount.

### EXAMPLES

The present invention will be decribed below in greater detail by giving Examples and Comparative Examples. The Tc shown in the following indicates the midpoint in every instance.

### Examples 1 to 6, Comparative Examples 1 to 3

Bi₂O₃, SrCO₃, Nd₂O₃ and CuO as starting materials were weighed to give the compositional ratios as shown in Table 1 below, followed by dry mixing. The resulting mixtures were each press-molded into a pellet of 10 mm in diameter and 1 mm in thickness, and the molded products were each reacted and sintered on an alumina boat at 870°C in the atmosphere, thus preparing copper oxide materials of the present invention and those of Comparative Examples.

The superconductivity of each oxide thus prepared was measured in a temperature range of from 4 K to 50 K. Results obtained are shown in Table 1 below.

As will be evident from Table 1, the oxide materials of the present invention exhibit the superconductivity, but on the other hand the oxide materials of Comparative Examples exhibited none at 8 K or higher.

**Table 1**

| Samples | Components (molar ratio) | | | | | |
|---|---|---|---|---|---|---|
| | Bi | Sr | Nd | Cu | O | Tc (K) |
| Example: | | | | | | |
| 1 | 1 | 0.8 | 0.2 | 1 | 3.6 | 23 |
| 2 | 0.9 | 1 | 0.1 | 1 | 3.6 | 19 |
| 3 | 0.5 | 0.8 | 0.2 | 1 | 3.0 | 10 |
| 4 | 1 | 1.5 | 0.4 | 1 | 4.9 | 9 |
| 5 | 1 | 1 | 0.05 | 1 | 3.7 | 11 |
| 6 | 1 | 0.5 | 0.3 | 0.5 | 4.0 | 8 |

| Comparative Example: | | | | | | |
|---|---|---|---|---|---|---|
| 1 | 1 | 1 | 0.005 | 1 | 3.5 | 7 |
| 2 | 1 | 1 | 1 | 1 | 5.0 | - |
| 3 | 1 | 0.9 | 0.6 | 1 | 4.5 | - |
| The mark "-" in the column for Tc indicates that no superconductivity transition took place at 3 K or higher. | | | | | | |

### Example 7

Using Bi₂O₃, SrCO₃ and CuO as starting materials and Pr₆O₁₁, Er₂O₃, CeO₂, Sm₂O₃, Eu₂O₃, Gd₂O₃ and Y₂O₃ as materials for lanthanoid elements, mixing and press-molding were carried out in the same manner as in Example 1, followed by reaction and sintering on alumina boats at 850°C, to obtain seven copper oxide materials of the present invention, represented by the compositional formula: BiSr_{0.9}Ln_{0.1}CuO_{δ} (Ln = Pr, Er, Ce, Sm, Eu, Gd or Y). Resistance measurement on each oxide thus prepared was carried out at 4 K or more to find that the materials in which Ln is Pr, Sm, Eu and Gd, respectively, exhibited the superconductivity transition at 10K or higher and the materials in which Ln is Y, Ce and Er, respectively, exhibited the superconductivity transition at 8 K or higher, showing that all are superior as superconductive materials.

### Examples 8 to 11, Comparative Examples 4 to 10

Using Bi₂O₃, SrCO₃, Nd₂O₃ and CuO as starting materials, these were weighed to give appropriate compositional ratios, followed by dry mixing. The resulting mixtures were each press-molding into a pellet of 10 mm in diameter and 1 mm in thickness, and the molded products were each reacted and sintered on an alumina boat at 870°C in the atmosphere, thus giving copper oxide materials of the present invention and those of Comparative Examples.

Each oxide thus prepared was subjected to EPMA analysis, and further the superconductivity thereof was measured in a temperature range of from 4 K to 70 K. Results obtained are shown in Table 2 below.

As will be evident from Table 2, the oxide materials of the present invention exhibit a good superconductivity, but on the other hand the oxide materials of Comparative Examples exhibited a reduced superconductivity.

**Table 2**

| Samples | Components (molar ratio) | | | | | |
|---|---|---|---|---|---|---|
| | Bi | Sr | Nd | Cu | O | Tc (K) |
| Example: | | | | | | |
| 8 | 2 | 2.5 | 0.3 | 1 | 7.0 | 22 |
| 9 | 2 | 1.5 | 0.5 | 1 | 6.25 | 25 |
| 10 | 2 | 2 | 0.2 | 1 | 6.3 | 50 |
| 11 | 2.5 | 2 | 0.3 | 1 | 7.2 | 27 |

| Comparative Example: | | | | | | |
|---|---|---|---|---|---|---|
| 4 | 0.4 | 1 | 0.1 | 1 | 2.8 | - |
| 5 | 1 | 1 | 0 | 1 | 3.5 | 8 |
| 6 | 3 | 1 | 0.1 | 1 | 6.8 | - |
| 7 | 1 | 1 | 1.5 | 1 | 6.3 | 5 |
| 8 | 3 | 3 | 0 | 1 | 8.5 | - |
| 9 | 1 | 0.4 | 0.2 | 1 | 3.2 | - |
| 10 | 2 | 3 | 0.3 | 1 | 7.5 | - |

### Example 12

Using Bi₂O₃, SrCO₃ and CuO as starting materials and Pr₆O₁₁, Er₂O₃, CeO₂, Sm₂O₃, Eu₂O₃, La₂O₃ and Y₂O₃ as materials for lanthanoid elements, mixing and press-molding were carried out in the same manner as in Example 1, followed by reaction and sintering on alumina boats at 850°C in the atmosphere, to obtain seven kinds of copper oxide materials of the present invention, represented by the compositional formula: BiSr_{1.8}Ln_{0.2}CuO_{δ} (Ln = Pr, Er, Ce, Sm, Eu, La or Y). Resistance measurement on each oxide thus prepared was carried out at 4 K or higher to find that the materials in which Ln is Pr, Sm, Eu and La, respectively, exhibited the superconductivity transition at 10 K or higher and the materials in which Ln is Y, Ce and Er, respectively, exhibited the superconductivity transition at 8 K or higher, showing that all are superior as superconductive materials.

### Example 13

Using Bi₂O₃, SrCO₃, CuO, Nd₂O₃ and also BaCO₃, CaCO₃, MgO as starting materials, mixing and press-molding were carried out in the same manner as in Example 1, followed by reaction and sintering on alumina boats at 850°C in the atmosphere, to obtain three kinds of copper oxide materials represented by the compositional formula: Bi₂Sr_{1.8}Nd_{0.1}A_{0.1}CuO_{δ} (A = Ba, Ca or Mg).

Resistance measurement on each oxide thus prepared was carried out at 4K or higher to find that all exhibited the superconductivity transition at 8 K or higher.

Also, two kinds of copper oxide materials represented by the compositional formula: BiSr_{1.3}Nd_{0.2}B_{0.5}CuO_{δ} (B = Ca or Mg) were reacted and sintered at 830°C in an environment of 0.1 atmospheric pressure of oxygen partial pressure. As a result, both exhibited the superconductivity transition at 30 K or more.

### Example 14

Using Bi₂O₃, SrCO₃ and CuO as starting materials and Pr₆O₁₁, Nd₂O₃, Sm₂O₃, Eu₂O₃ and Gd₂O₃ as materials for lanthanoid elements, mixing and press-molding were carried out in the same manner as in Example 1, followed by reaction and sintering on alumina boats at 850°C in the atmosphere, to obtain three kinds of copper oxide materials of the present invention, represented by the compositional formula: BiSr_{0.9}A_{0.05}B_{0.05}CuO_{δ} [(A,B) = (Pr,Gd), (Nd, Gd) or (Sm, Eu)]. Resistance measurement on each oxide thus prepared was carried out at 4 K or higher to find that they exhibited the superconductivity transition at 8 K or higher, showing that all are superior as superconductive materials.

### Example 15

Using Bi₂O₃, SrCO₃ and CuO as starting materials and La₂O₃, Pr₆O₁₁, Sm₂O₃, Eu₂O₃ and Gd₂O₃ as materials for lanthanoid elements, mixing and press-molding were carried out in the same manner as in Example 1, followed by reaction and sintering on alumina boats at 850°C in the atmosphere, to obtain three kinds of copper oxide materials of the present invention, represented by the compositional formula: Bi₂Sr_{1.8}A_{0.1}B_{0.1}CuO_{δ} [(A,B) = (La,Gd), (Pr, Gd) or (Sm, Eu)]. Resistance measurement on each oxide thus prepared was carried out at 4 K or higher to find that they exhibited the superconductivity transition at 8 K or higher, showing that all are superior as superconductive materials.

### Examples 16 to 24

Using Bi₂O₃, SrCO₃ and CuO as starting materials and Y₂O₃, Pr₂O₃, Nd₂O₃, Sm₂O₃, Eu₂O₃, Gd₂O₃, Tb₄O₇, Dy₂O₃ and Ho₂O₃ mixing and press-molding were carried out in the same manner as Example 1, followed by reaction and sintering on alumina boats at 930°C in the atmosphere to obtain nine kinds of copper oxide materials of the present invention, represented by the compositional formula: BiSr_{1.35}Ln_{0.15}CuO_{δ} (Ln = Y, Pr, Nd, Sm, Eu, Gd, Tb, Dy or Ho).

The superconductivity of each oxide thus prepared was measured in a temperature range of from 4K to 70K. Result obtained are shown in Table 3 below.

As will be evident from Table 3, the oxide materials of the present invention have a high Tc.

**Table 3**

| BiSr_{1.35}Ln_{0.15}CuO_{δ} (δ ≧ 3) | | |
|---|---|---|
| | Ln | Tc(K) |
| Example | | |
| 16 | Y | 54 |
| 17 | Pr | 57 |
| 18 | Nd | 55 |
| 19 | Sm | 55 |
| 20 | Eu | 47 |
| 21 | Gd | 51 |
| 22 | Tb | 45 |
| 23 | Dy | 51 |
| 24 | Ho | 45 |

X-ray diffraction on all of the above Examples was measured to examine the lattice constant to find that all had the basic structure of a tetragonal system having the lattice constant of a = 3.8 to 3.9 Å, c = 24 to 25 Å or c = 30 to 31 Å. [1Å = 0.1 nm].

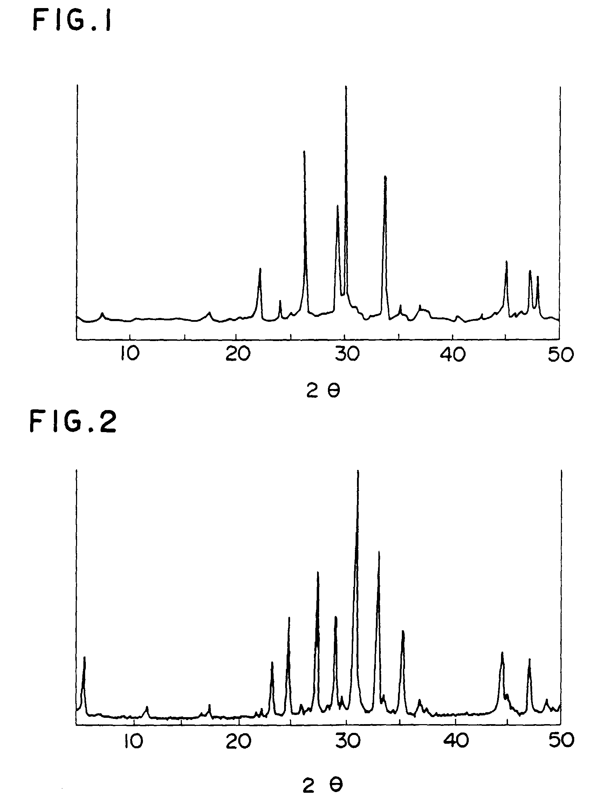

Their patterns were similar to thoses of Bi₂Sr₂CuO_{δ} and Bi₂Sr₂CaCuO_{δ} (an X-ray a pattern of the product of Example 10 is shown in Fig. 1, and that of Example 18 in Fig. 2).

This indicates that the copper oxide material of the present invention has a layer structure, and has a laminated structure comprising (BiO)₂ layers and a layer held between them and having a perovskite-like structure.

## Claims

1. A metal oxide material represented by the compositional formula:
LnₓBi_{y}A_{z}CuO_{δ}
wherein Ln is at least one element selected from the group consisting of lanthanoid elements and yttrium; A is at least one element selected from alkaline earth metals; and 0.01 ≦ x ≦ 0.5, 0.5 ≦ y < 3, 0.5 ≦ z < 3, and 3 < δ.

2. The metal oxide material according to Claim 1, wherein 0.2 ≦ x ≦ 0.35, 1.8 ≦ y ≦ 2.2, 2.6 ≦ z ≦ 2.8 and 3 ≦ δ ≦ 7.3.

3. The metal oxide material according to claim 1 or 2, comprising as said alkaline earth metal at least one selected from the group consisting of calcium, strontium, barium and magnesium.

4. The metal oxide material according to any preceding claim containing as said lanthanoid element at least one selected from the group consisting of La, Pr, Sm, Eu, Nd, Gd, Tb, Dy, Ho, Er and Ce.

5. The metal oxide material according to claim 1, wherein said material is represented by the compositional formula: BiSr₁₋ₓLnₓCuO_{δ} , where Ln is at least one element selected from the group consisting of lanthanoid elements and yttrium; and 0.08 ≦ x ≦ 0.12, and 3.5 ≦ δ ≦ 3.6.

6. The metal oxide material according to Claim 1, wherein said material is represented by the compositional formula: Bi₂(Sr₁₋ₓLnₓ)₂CuO_{δ}, where Ln is at least element selected from the group consisting of lanthanoid elements and yttrium;and 0.01 ≦ x ≦ 0.5, and 6 ≦ δ ≦ 6.5.

7. The metal oxide material according to Claim 1, containing as said lanthanoid element at least one selected from the group consisting of La, Pr, Sm, Eu, Nd and Gd.

8. The metal oxide material according to Claim 1, wherein said material is represented by the compositional formula: BiSr_{1.5-x}LnₓCuO_{δ}, where Ln is at least one element selected from the group consisting of lanthanoid elements and yttrium.

9. The metal oxide material according to Claim 6, containing as said lanthanoid element at least one selected from the group consisting of Y, Pr, Sm, Eu, Nd, Tb, Dy, Ho and Gd.

10. The metal oxide material according to any preceding claim, wherein the electrical resistance disappears at a temperature higher than the boiling point of liquid helium.

11. The metal oxide material according to any preceding claim, wherein said metal oxide material has a layer structure as the basic crystal structure thereof comprising a layer having a perovskite -like structure, held between (BiO)₂ layers.

12. The metal oxide material of claim 8 which is represented by the compositional formula Bi Sr_{1.5-x}Lnₓ Cu O_{δ} where 0.1 ≤ x ≤ 0.2.

13. A method of preparing a metal oxide material as claimed in any of claims 1-12, which comprises heating together powdered starting materials at a temperature of not more than 900°C.

14. A thin film of metal oxide material according to any of claims 1-12.

## Patentansprüche

1. Metalloxidmaterial, das durch die nachstehende Zusammensetzungsformel repräsentiert wird:
LnₓBi_{y}A_{z}CuO_{δ}
wobei Ln mindestens ein Element ist, das aus der Gruppe bestehend aus Lanthanoidelementen und Yttrium ausgewählt ist; A ist mindestens ein Element, das aus Erdalkalimetallen ausgewählt ist; und 0,01 ≤ x ≤ 0,5, 0,5 ≤ y < 3, 0,5 ≤ z < 3, und 3 < δ.

2. Metalloxidmaterial nach Anspruch 1, wobei 0,2 ≤ x ≤ 0,35, 1,8 ≤ y ≤ 2,2, 2,6 ≤ z ≤ 2,8 und 3 ≤ δ ≤ 7,3.

3. Metalloxidmaterial nach Anspruch 1 oder Anspruch 2, das als das Erdalkalimetall mindestens ein Erdalkalimetall umfaßt, das aus der Gruppe bestehend aus Calcium, Strontium, Barium und Magnesium ausgewählt ist.

4. Metalloxidmaterial nach einem der vorstehenden Ansprüche, das als das Lanthanoidelement mindestens ein Element enthält, das aus der Gruppe bestehend aus La, Pr, Sm, Eu, Nd, Gd, Tb, Dy, Ho, Er und Ce ausgewählt ist.

5. Metalloxidmaterial nach Anspruch 1, wobei das Material durch die Zusammensetzungsformel BiSr₁₋ₓLnₓCuO_{δ} repräsentiert wird, wobei Ln mindestens ein Element ist, das aus der Gruppe bestehend aus Lanthanoidelementen und Yttrium ausgewählt ist; und 0,08 ≤ x ≤ 0,12, und 3,5 ≤ δ ≤ 3,6.

6. Metalloxidmaterial nach Anspruch 1, wobei das Material durch die Zusammensetzungsformel Bi₂(Sr₁₋ₓLnₓ)₂CuO_{δ} repräsentiert wird, wobei Ln mindestens ein Element ist, das aus der Gruppe bestehend aus Lanthanoidelementen und Yttrium ausgewählt ist; und 0,01 ≤ x ≤ 0,5 und 6 ≤ δ ≤ 6,5.

7. Metalloxidmaterial nach Anspruch 1, das als das Lanthanoidelement mindestens ein Element enthält, das aus der Gruppe bestehend aus La, Pr, Sm, Eu, Nd und Gd ausgewählt ist.

8. Metalloxidmaterial nach Anspruch 1, wobei das Material durch die Zusammensetzungsformel BiSr_{1,5-x}LnₓCuO_{δ} repräsentiert wird, wobei Ln mindestens ein Element ist, das aus der Gruppe bestehend aus Lanthanoidelementen und Yttrium ausgewählt ist.

9. Metalloxidmaterial nach Anspruch 6, das als das Lanthanoidelement mindestens ein Element enthält, das aus der Gruppe bestehend aus Y, Pr, Sm, Eu, Nd, Tb, Dy, Ho und Gd ausgewählt ist.

10. Metalloxidmaterial nach einem der vorstehenden Ansprüche, wobei der elektrische Widerstand bei einer Temperatur verschwindet, die höher als der Siedepunkt von flüssigem Helium ist.

11. Metalloxidmaterial nach einem der vorstehenden Ansprüche, wobei das Metalloxidmaterial als seine grundlegende Kristallstruktur eine Schichtstruktur aufweist, die eine Schicht mit einer perovskitartigen Struktur umfaßt, die zwischen (BiO)₂-Schichten gehalten wird.

12. Metalloxidmaterial nach Anspruch 8, das durch die Zusammensetzungsformel BiSr_{1,5-x}LnₓCuO_{δ} repräsentiert wird, wobei 0,1 ≤ x ≤ 0,2.

13. Verfahren zur Herstellung eines Metalloxidmaterials nach einem der Ansprüche 1 bis 12, das das gemeinsame Erwärmen der gepulverten Ausgangsmaterialien bei einer Temperatur von nicht höher als 900 °C umfaßt.

14. Dünnschicht aus einem Metalloxidmaterial nach einem der Ansprüche 1 bis 12.

## Revendications

1. Matière à base d'oxyde métallique répondant à la formule de composition :
LnₓBi_{y}A_{z}CuO_{δ}
dans laquelle Ln est au moins un élément choisi dans le groupe constitué des éléments lanthanoïdes et de l'yttrium ; A est au moins un élément choisi parmi les métaux alcalino-terreux ; et 0,01 ≤ x ≤ 0,5, 0,5 ≤ y < 3, 0,5 ≤ z < 3, et 3 < δ.

2. Matière à base d'oxyde métallique selon la revendication 1, dans laquelle 0,2 ≤ x ≤ 0,35, 1,8 ≤ y < 2,2, 2,6 ≤ z ≤ 2,8 et 3 ≤ δ ≤ 7,3.

3. Matière à base d'oxyde métallique selon les revendications 1 ou 2, comprenant comme métal alcalino-terreux au moins un métal choisi dans le groupe constitué du calcium, du strontium, du baryum et du magnésium.

4. Matière à base d'oxyde métallique selon l'une quelconque des revendications précédentes, contenant comme élément lanthanoïde au moins un élément choisi dans le groupe constitué de La, Pr, Sm, Eu, Nd, Gd, Tb, Dy, Ho, Er et Ce.

5. Matière à base d'oxyde métallique selon la revendication 1, dans laquelle cette matière est représentée par la formule de composition : BiSr₁₋ₓLnₓCuO_{δ}, dans laquelle Ln est au moins un élément choisi dans le groupe constitué des éléments lanthanoïdes et de l'yttrium ; et 0,08 ≤ x ≤ 0,12 et 3,5 ≤ δ ≤ 3,6.

6. Matière à base d'oxyde métallique selon la revendication 1, dans laquelle cette matière est représentée par la formule de composition : Bi₂(Sr₁₋ₓLnₓ)₂CuO_{δ}, dans laquelle Ln est au moins un élément choisi dans le groupe constitué des éléments lanthanoïdes et de l'yttrium ; et 0,01 ≤ x ≤ 0,5 et 6 ≤ δ ≤ 6,5.

7. Matière à base d'oxyde métallique selon la revendication 1, contenant comme élément lanthanoïde au moins un élément choisi dans le groupe constitué de La, Pr, Sm, Eu, Nd et Gd.

8. Matière à base d'oxyde métallique selon la revendication 1, dans laquelle cette matière est représentée par la formule de composition : BiSr_{1,5-x}LnₓCuO_{δ}, dans laquelle Ln est au moins un élément choisi dans le groupe constitué des éléments lanthanoïdes et de l'yttrium.

9. Matière à base d'oxyde métallique selon la revendication 6, contenant comme élément lanthanoïde au moins un élément choisi dans le groupe constitué de Y, Pr, Sm, Eu, Nd, Tb, Dy, Ho et Gd.

10. Matière à base d'oxyde métallique selon l'une quelconque des revendications précédentes, dans laquelle la résistance électrique disparaît à une température supérieure au point d'ébullition de l'hélium liquide.

11. Matière à base d'oxyde métallique selon l'une quelconque des revendications précédente, dans laquelle cette matière à base d'oxyde métallique a comme structure cristalline fondamentale une structure en couches comprenant une couche ayant une structure analogue à la perovskite maintenue entre deux couches de (BiO)₂.

12. Matière à base d'oxyde métallique selon la revendication 8, qui est représentée par la formule de composition : BiSr_{1,5-x}LnₓCuO_{δ} où 0,1 ≤ x ≤ 0,2.

13. Procédé de préparation d'une matière à base d'oxyde métallique selon l'une quelconque des revendications 1 à 12, qui comprend le fait de chauffer ensemble des matières de départ pulvérisées à une température non supérieure à 900 °C.

14. Film mince de matière à base d'oxyde métallique selon l'une quelconque des revendications 1 à 12.
